# EUROPEAN PATENT APPLICATION

(11) **EP 2 578 075 A1**
(43) Date of publication of application: **10.04.2013**
(21) Application number: 11786727.5
(22) Date of filing: 26.05.2011
(51) Int. Cl.: A01G 9/14, A01G 13/02, H01L 31/052

(54) **WAVELENGTH CONVERSION FILM**

(30) Priority: 28.05.2010 JP 2010123176
(71) Applicant: Asahi Glass Company, Limited, Tokyo 100-8405 (JP)
(72) Inventor: SHIMOI, Yasuko, Tokyo 100-8405 (JP); ARUGA, Hiroshi, Tokyo 100-8405 (JP)
(74) Representative: Müller-Boré & Partner Patentanwälte
(86) International application number: PCT/JP2011/062132
(87) International publication number: WO 2011/149028

(57) **Abstract**

To provide a wavelength conversion film which is capable of maintaining an optical wavelength converting function for a long term as compared with conventional wavelength conversion films.

A wavelength conversion film 1 comprising a single layered film consisting of a resin composition containing a thermoplastic resin 10, a wavelength converting material 12 and a specific nickel(II) dialkyldithiocarbamate 14, or a laminated film having a wavelength converting layer consisting of the resin composition, wherein the alkyl group of the specific nickel(II) dialkyldithiocarbamate 14 is an ethyl group or a butyl group, and the content of the specific nickel(II) dialkyldithiocarbamate 14 is from 20 to 250 parts by mass per 100 parts by mass of the wavelength converting material 12.

## Description

### TECHNICAL FIELD

The present invention relates to a wavelength conversion film used for an agricultural film, a cover film for photovoltaic generation or the like.

### BACKGROUND ART

Greenhouse farming for cultivation of plants in a greenhouse is widely adopted because it brings much greater yield amount and much better quality than open field farming. Recently, for the purpose of further improvement of yield and quality, adjustment of picking season, reducing the period of cultivation, and so on, it has been attempted to convert ultraviolet light, which is harmful to plants, to blue light, which is helpful for photosynthesis, or to convert a light of green to yellow range, which has low photosynthesis efficiency, to a light of orange to red range, which has high efficiency of photosynthesis, by means of an agricultural film used for a greenhouse. Further, in a plant factory, plants are cultivated by using LED lamps having various wavelengths, and it has been proved that LED lamps having various wavelengths provide an elongation effect, a fruition promoting effect, a disease decreasing effect and the like. Therefore, the wavelength conversion film which increases light in a specific wavelength area as compared with sunlight, without using artificial light source, is very useful for cultivation of plants.

As the wavelength conversion film which has a function to convert a light with a specific wavelength to a light with a different wavelength (hereinafter referred to as wavelength converting function), a wavelength conversion film containing an inorganic ultraviolet blocking material and a wavelength converting material has been proposed (Patent Document 1).

With respect to the wavelength conversion film, though the inorganic ultraviolet blocking material is used in combination for the purpose of improvement of the weather resistance of the wavelength converting material, the weather resistance had been inadequate yet, and there is a problem that when it is exposed to the outside for a long term, the color of the film fades and the wavelength converting function decreases a little.

### PRIOR ART DOCUMENTS

### PATENT DOCUMENT(S)

Patent Document 1: International Publication No. WO 2008/126766

### DISCLOSURE OF INVENTION

### TECHNICAL PROBLEM

The present invention provides a wavelength conversion film which is capable of maintaining the optical wavelength converting function for a long term as compared with conventional wavelength conversion films.

### SOLUTION TO PROBLEM

The present invention provides the following.
(1) A wavelength conversion film comprising a single layered film consisting of a resin composition containing a thermoplastic resin, a wavelength converting material and a nickel(II) dialkyldithiocarbamate, or a laminated film having a wavelength converting layer consisting of the resin composition,
   wherein the alkyl group of the nickel(II) dialkyldithiocarbamate is an ethyl group or a butyl group, and
   the content of the nickel(II) dialkyldithiocarbamate is from 20 to 250 parts by mass per 100 parts by mass of the wavelength converting material.
(2) The wavelength conversion film according to the above (1), wherein the thermoplastic resin is a fluororesin.
(3) The wavelength conversion film according to the above (1) or (2), wherein the resin composition further contains an inorganic ultraviolet blocking material.
(4) The wavelength conversion film according to the above (1) or (2),wherein the laminated film further has an ultraviolet blocking layer containing an inorganic ultraviolet blocking material.
(5) The wavelength conversion film according to any one of the above (1) to (4), wherein the wavelength converting material is a perylene colorant.
(6) The wavelength conversion film according to any one of the above (1) to (5), wherein the resin composition consists of only the thermoplastic resin, the wavelength converting material and the nickel(II) dialkyldithiocarbamate.
(7) The wavelength conversion film according to any one of the above (1) to (5), wherein the resin composition consists of only the thermoplastic resin, the wavelength converting material, the nickel(II) dialkyldithiocarbamate and the inorganic ultraviolet blocking material.
(8) The wavelength conversion film according to any one of the above (1) to (7), wherein the content of the wavelength converting material is from 0.005 to 0.10 mass% per 100 mass% of the resin composition.
(9) The wavelength conversion film according to any one of the above (1) to (8), wherein the thermoplastic resin is an ethylene/tetrafluoroethylene copolymer or a vinylidene fluoride polymer.
(10) An agricultural film using the wavelength conversion film according to any one of the above (1) to (9).
(11) A cover film for photovoltaic generation, using the wavelength conversion film according to any one of the above (1) to (9).

### ADVENTAGEOUS EFFECTS OF INVENTION

The present invention provides a wavelength conversion film which is capable of maintaining the optical wavelength converting function for a long term as compared with conventional wavelength conversion films.

Further, when the thermoplastic resin is a fluororesin, the wavelength conversion film of the present invention provides a high intensity of a light with a wavelength after conversion as compared with the conventional wavelength conversion films.

### BRIEF DESCRIPTION OF DRAWINGS

Fig. 1 is a cross-sectional view illustrating an example of the wavelength conversion film of the present invention.
Fig. 2 is a cross-sectional view illustrating another example of the wavelength conversion film of the present invention.

### DESCRIPTION OF EMBODIMENTS

### < Wavelength conversion film >

The wavelength conversion film of the present invention comprises the following single layered film or laminated film.
(α) a single layered film consisting of a resin composition containing a thermoplastic resin, a wavelength converting material and a specific nickel(II) dialkyldithiocarbamate.
(β) a laminated film having a wavelength converting layer consisting of the resin composition containing a thermoplastic resin, a wavelength converting material and a specific nickel(II) dialkyldithiocarbamate.
Here, in this specification, a "film" includes a "sheet".

### [EMBODIMENT 1]

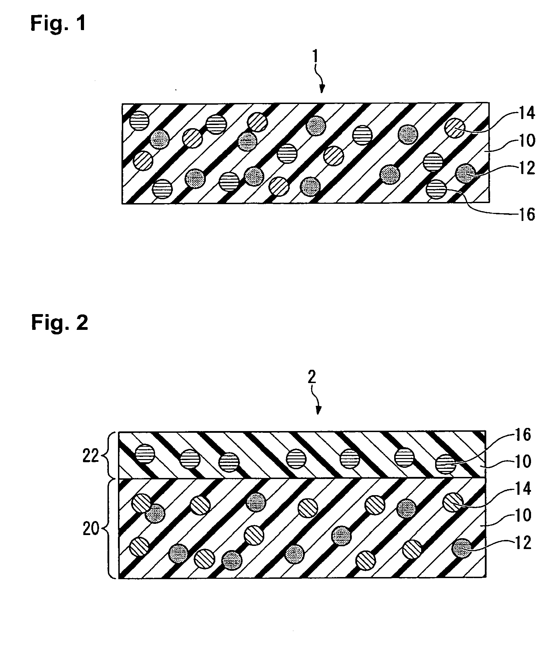

Fig. 1 is a cross-sectional view illustrating an embodiment of the wavelength conversion film of the present invention. A wavelength conversion film 1 is a single layered film consisting of a resin composition having a wavelength converting material 12, a specific nickel(II) dialkyldithiocarbamate 14 and an inorganic ultraviolet blocking material 16 dispersed in a thermoplastic resin 10.

The thickness of the wavelength conversion film is preferably from 40 to 150 µm. When the thickness of the wavelength conversion film is at least 40 µm, it has adequate strength. When the thickness of the wavelength conversion film is at most 150 µm, it has adequate visible light transmittance.

### (Thermoplastic resin)

The thermoplastic resin may, for example, be an olefin resin, a chlororesin, an acrylic resin, an ester resin or a fluororesin, and is preferably an olefin resin, an acrylic resin or a fluororesin, particularly preferably a fluororesin, from the viewpoint of transparency and weather resistance.

The olefin resin may, for example, be a homopolymer of an α-olefin (such as polyethylene or polypropylene), a copolymer of α-olefins (such as an ethylene/propylene copolymer, an ethylene/buthene-1 copolymer, an ethylene/hexene copolymer or an ethylene/octene copolymer) or a copolymer of an α-olefin with another monomer (such as an ethylene/vinyl acetate copolymer, an ethylene/acrylic acid copolymer, an ethylene/methyl methacrylate copolymer or an ethylene/vinyl acetate/methyl methacrylate copolymer).

The chlororesin may, for example, be polyvinyl chloride, a vinyl chloride/methyl methacrylate copolymer or polyvinylidene chloride.

The acrylic resin may, for example, be a polymer obtained by polymerizing at least one monomer selected from the group consisting of methyl acrylate, ethyl acrylate, n-propyl acrylate, n-butyl acrylate, isopropyl acrylate, 2-ethylhexyl acrylate, decyl acrylate, methyl methacrylate, ethyl methacrylate, n-propyl methacrylate, n-butyl methacrylate, isopropyl methacrylate, 2-ethylhexyl methacrylate and decyl methacrylate.

The ester resin may, for example, be polyethylene terephthalate or polybutylene naphthalate.

The fluororesin may, for example, be a vinyl fluoride polymer, a vinylidene fluoride polymer (hereinafter referred to as PVDF), a vinylidene fluoride/hexafluoropropylene copolymer, a tetrafluoroethylene/hexafluoropropylene/vinylidene fluoride copolymer (hereinafter referred to as THV), a tetrafluoroethylene/propylene copolymer, a tetrafluoroethylene/vinylidene fluoride/propylene copolymer, an ethylene/tetrafluoroethylene copolymer (hereinafter referred to as ETFE), a hexafluoropropylene/tetrafluoroethylene copolymer (hereinafter referred to as HFP), or a perfluoro(alkyl vinyl ether)/tetrafluoroethylene copolymer (hereinafter referred to as PFA).

Among them, from the viewpoint of transparency and weather resistance, ETFE, HFP, PFA, THV or PVDF is preferred, and ETFE or PVDF is more preferred.

### (Wavelength converting material)

The wavelength converting material is a material which has an absorption wavelength and an emission wavelength in the ultraviolet range or the visible light range. Therefore, it does not include a material which only absorbs or only reflects a light with a specific wavelength, such as a color pigment (e.g. white titanium oxide or phthalocyanine blue).

The wavelength converting material may, for example, be an organic wavelength converting material or an inorganic wavelength converting material.

The organic wavelength converting material may, for example, be a fluorescent colorant (a fluorescent pigment), which absorbs ultraviolet or visible light and emits a fluorescent color.

The followings may be mentioned as examples of the fluorescent colorant:
a colorant which emits light in an ultraviolet range (from 300 nm to 400 nm), such as a terphenylene colorant or an oxazoline colorant;
a colorant which emits light in a blue to green wavelength range (from 400 nm to 500 nm), such as a coumarin colorant;
a colorant which emits light in a green to red wavelength range (from 500 nm to 800 nm) depending on its substituted group, such as an indole colorant;
a colorant which emits light in a yellow to red wavelength range (from 500 nm to 800 nm), such as a malachite green colorant or a rhodamine colorant;
a colorant which emits light in a deep red wavelength range (from 630 nm to 750 nm), such as an oxazine colorant; and
a colorant which emits light in a wide range of wavelength depending on its substituted group, such as a pi-conjugated organic colorant (e.g. an anthracene colorant, a pyrene colorant or a perylene colorant).

Among these colorants, the pi-conjugated organic colorant or the oxazine colorant is preferred, the pi-conjugated organic colorant is more preferred, and the perylene colorant is further preferred, because it has a peak emission wavelength in a range from 600 to 700 nm, which is the most important for photosynthesis.

The inorganic wavelength converting material may, for example, be a phosphorescent pigment, which absorbs ultraviolet or visible light and emits visible light.

The phosphorescent pigment is generally a white pigment which has a particle size of about from 2 to 20 µm. The larger its particle size is, the higher its wavelength converting efficiency is, however, when the particle is submicron size, the wavelength converting function deteriorates. As a result, the absorption and emission are usually at quite low level. Thus, an agricultural film which contains a phosphorescent pigment has a sunlight blocking effect which is greater than the effect of amplifying a specific wavelength of the sunlight, and therefore, it is not suitable for cultivation of a plant, for which the sunlight is indispensable, however, it is capable of providing a light to plants even after sunset.

One of the wavelength converting materials may be used alone, or two or more may be used in combination. When two or more wavelength converting materials are used in combination, the emission spectrum of one of them may partly overlap with the absorption spectrum of another wavelength converting material. Further, an organic wavelength converting material and an inorganic wavelength converting material may be used in combination. Furthermore, although many wavelength converting materials are down-conversion type, which absorbs light with short wavelength having high energy and emits light with long wavelength having low energy, up-conversion type, the reverse of the former, may also be used.

The content of the wavelength converting material is preferably from 0.005 to 0.10 mass%, more preferably from 0.015 to 0.05 mass% in the resin composition (100 mass%). If the content of the wavelength converting material is too high, the wavelength converting efficiency decreases, the light absorbing amount tends to be large and the absorption wavelength range is widened, so the light blocking effect tends to be strong.

And, the content of the wavelength converting material is preferably adjusted so that the photosynthetically active radiation (PAR) of the light which transmits through the wavelength converting film is at least 30% of PAR of the sunlight. If PAR of the transmitting light is less than 30%, the growth inhibition influence caused by the lack of amount of light is larger than the photosynthesis promoting effect brought by the wavelength conversion.

The wavelength converting material contained in the wavelength conversion film is preferably particulate, and the volume average particle size is more preferably from 0.001 to 0.5 µm.

### (Nickel(II) dialkyldithiocarbamate)

A nickel(II) dialkyldithiocarbamate is a singlet oxygen quencher. The singlet oxygen quencher is a material which traps and deactivates singlet oxygen made by the oxygen in the air activated by light energy. The wavelength converting material and the singlet oxygen quencher coexist in the wavelength conversion film to deactivate active oxygen before it attacks and deteriorates the wavelength converting material.

As the nickel(II) dialkyldithiocarbamate, nickel(II) diethyldithiocarbamate or nickel(II) dibuthyldithiocarbamate may be used from the viewpoint of dispersibility in the thermoplastic resin (particularly, a fluororesin), weather resistance and light resistance. As the nickel(II) dialkyldithiocarbamate, nickel(II) diethyldithiocarbamate is particularly preferred.

As the singlet oxygen quencher, various metal complexes (a metal complex of benzenethiol, a copper (II) dialkyldithiocarbamate and the like) are known. However, metal complexes other than the specific nickel(II) dialkyldithiocarbamate cannot function effectively as a singlet oxygen quencher in the wavelength conversion film, since the dispersibility in the thermoplastic resin (particularly, a fluororesin) is inferior.

The content of the specific nickel(II) dialkyldithiocarbamate is from 20 to 250 parts by mass, preferably from 30 to 150 parts by mass per 100 parts by mass of the wavelength converting material. The content of the specific nickel(II) dialkyldithiocarbamate is at least 20 parts by mass, whereby it is possible to maintain the light wavelength converting function for a long term. The content of the specific nickel(II) dialkyldithiocarbamate is at most 250 parts by mass, whereby the visible light transmittance is maintained high and the effect of improving weather resistance of the wavelength converting function is realized.

The specific nickel(II) dialkyldithiocarbamate contained in the wavelength conversion film is preferably particulate, and the volume average particle size is more preferably from 0.001 to 0.5 µm.

### (Inorganic ultraviolet blocking material)

An inorganic ultraviolet blocking material is a component further improving the weather resistance of the wavelength conversion film.

The inorganic ultraviolet blocking material may, for example, be at least one metal oxide selected from the group consisting of cerium oxide, zinc oxide, titanium oxide and iron oxide. The inorganic ultraviolet blocking material is preferably cerium oxide or zinc oxide.

The inorganic ultraviolet blocking material is more preferably the above metal oxide covered with at least one inorganic oxide selected from the group consisting of silica, zirconia and alumina, from the following viewpoints:
(i) it inhibits corrosion of the metal oxide caused by hydrogen fluoride generated from the fluororesin at the time of film forming and outdoor use, and it maintains the ultraviolet blocking function for a long term; and
(ii) it inhibits photoactivity of the photocatalyst such as cerium oxide, zinc oxide, titanium oxide, etc., as a result, it inhibits deterioration of the thermoplastic resin and decomposition of the wavelength converting material.

For improving the dispersibility in the thermoplastic resin, it is also preferred that the surface of the above inorganic oxide is additionally hydrophobized with silicone, a silane coupling agent, etc.

The content of the inorganic ultraviolet blocking material is preferably from 0.03 to 6 mass%, more preferably from 0.1 to 3 mass%, in the resin composition (100 mass%). When the content of the inorganic ultraviolet blocking material is at least 0.03 mass%, a sufficient ultraviolet blocking function can be obtained. When the content of the inorganic ultraviolet blocking material is at most 6 mass%, the visible light transmittance can be further improved. Further, when the content of the inorganic ultraviolet blocking material is at most 20 mass%, a film having a sufficient visible light transmittance for agricultural use can be obtained.

The inorganic ultraviolet blocking material contained in the wavelength conversion film is preferably particulate, and the volume average particle size is more preferably from 0.02 to 0.5 µm.

### (Other additives)

The resin composition preferably contains no additives other than the wavelength converting material, the specific nickel(II) dialkyldithiocarbamate and the inorganic ultraviolet blocking material, with a view to suppressing adverse effects to the wavelength converting material as much as possible. That is, the resin composition preferably consists of only the thermoplastic resin, the wavelength converting material and the specific nickel(II) dialkyldithiocarbamate, or preferably consists of only the thermoplastic resin, the wavelength converting material, the specific nickel(II) dialkyldithiocarbamate and the inorganic ultraviolet blocking material.

Other additives may, for example, be an organic ultraviolet blocking material (an organic ultraviolet absorbent or the like) or a hindered amine light stabilizer (HALS).

Particularly, since the organic ultraviolet absorbent is an organic component having a low molecular weight, even if the organic ultraviolet absorbent and the wavelength converting material are contained in separate layers, the organic ultraviolet absorbent migrates by the heat of the sunlight and moves to a layer containing the wavelength converting material. The organic ultraviolet absorbent interacts with the wavelength converting material to decrease the wavelength converting function of the wavelength converting material.

### (Method for producing wavelength conversion film)

The wavelength conversion film can be produced by a method of forming the resin composition into a form of a film. The wavelength converting material, the specific nickel(II) dialkyldithiocarbamate and the inorganic ultraviolet blocking material may be formed into master batches separately and then formed. However, since active hydrogen may be generated by the heat and hydrogen fluoride generated when the wavelength converting material is kneaded into the fluororesin, the wavelength converting material and the nickel(II) dialkyldithiocarbamate are preferably kneaded together and formed into a mater batch with a view to obtaining the effect of the nickel(II) dialkyldithiocarbamate further effectively.

### [EMBODIMENT 2]

Fig. 2 is a cross-sectional view illustrating another embodiment of the wavelength conversion film of the present invention. The wavelength conversion film 2 is a laminated film which has a wavelength converting layer 20 consisting of a resin composition having a wavelength converting material 12 and a specific nickel(II) dialkyldithiocarbamate 14 dispersed in a thermoplastic resin 10, and an ultraviolet blocking layer 22 consisting of a resin composition having an inorganic ultraviolet blocking material 16 dispersed in a thermoplastic resin 10.

### (Wavelength converting layer)

The thermoplastic resin may be the thermoplastic resin exemplified in Embodiment 1.

The wavelength converting material may be the wavelength converting material exemplified in Embodiment 1.

The content of the wavelength converting material is preferably the same one as in Embodiment 1.

The specific nickel(II) dialkyldithiocarbamate is preferably the same one as in Embodiment 1.

The content of the specific nickel(II) dialkyldithiocarbamate is in the same range as in Embodiment 1.

The thickness of the wavelength converting layer is preferably from 40 to 300 µm. When the thickness of the wavelength converting layer is at least 40 µm, a wavelength converting film having a sufficient strength can be obtained. When the thickness of the wavelength converting layer is at most 300 µm, a wavelength converting layer having a sufficient visible light transmittance can be obtained.

### (Ultraviolet blocking layer)

The thermoplastic resin may be the thermoplastic resin exemplified in Embodiment 1.

The inorganic ultraviolet blocking material may be the inorganic ultraviolet blocking material exemplified in Embodiment 1.

The content of the inorganic ultraviolet blocking material is preferably in the same range as in Embodiment 1.

The thickness of the ultraviolet blocking layer is preferably from 6 to 250 µm, more preferably from 10 to 150 µm. When the thickness of the ultraviolet blocking layer is at least 6 µm, a wavelength converting film having a sufficient strength can be obtained. When the thickness of the ultraviolet blocking layer is at most 250 µm, an ultraviolet blocking layer having a sufficient visible light transmittance can be obtained.

### (Method for producing wavelength conversion film)

The wavelength conversion film can be produced by laminating the wavelength converting layer and the ultraviolet blocking layer. The lamination method may, for example, be a coextrusion method using a multiple-layer die, a method that after a layer is formed in a film form, the other layer is subject to extrusion lamination, or a method that the wavelength converting layer and the ultraviolet blocking layer are formed in a film form respectively, followed by lamination.

### [OTHER EMBODIMENT]

The wavelength conversion film of the present invention is not limited to the ones in First and Second Embodiments and may be a wavelength conversion film comprising a single layered film consisting of the resin composition, or a laminated film having a wavelength converting layer consisting of the resin composition.

For example, it may be the one having a wavelength converting layer formed on the surface of a substrate film consisting substantially of the thermoplastic resin without containing a wavelength converting material, a specific nickel(II) dialkyldithiocarbamate and an inorganic ultraviolet blocking material, or having a wavelength converting layer and an ultraviolet blocking layer formed on the surface of such a substrate film. Further, it may be the one having a coating film which is obtained by applying and drying a composition for forming a coating film, containing the thermoplastic resin, the wavelength converting material, the specific nickel(II) dialkyldithiocarbamate and a liquid medium (an organic solvent, water or the like) on the surface of the substrate film or the wavelength converting layer, or the one having a carting film which is obtained by applying and drying a composition for forming a coating film containing the thermoplastic resin, the wavelength converting material, the specific nickel(II) dialkyldithiocarbamate, the inorganic ultraviolet blocking material and a liquid medium on the surface of the substrate film.

### (Mode of Actions and Effects)

With respect to the above-explained wavelength conversion film of the present invention, since the wavelength converting material and the specific nickel(II) dialkyldithiocarbamate are used in combination and the content of the specific nickel(II) dialkyldithiocarbamate is from 20 to 250 parts by mass per 100 parts by mass of the wavelength converting material, it is possible to maintain the optical wavelength converting function for a long term, as compared with conventional wavelength conversion films, from the following reasons.

The deterioration of the wavelength converting material of the wavelength conversion film is considered to be caused by the cleavage of the chemical bonds of the wavelength converting material, because the wavelength converting material absorbs a specific light, particularly ultraviolet light, and oxygen in the air is activated by ultraviolet light to be singlet oxygen to attack the wavelength converting material.

In the wavelength conversion film in Patent Document 1, the deterioration of the wavelength converting material is suppressed by blocking ultraviolet light by an inorganic ultraviolet blocking material. In order to further improve weather resistance, it is considered to be useful to deactivate activated singlet oxygen.

Thus, in the wavelength conversion film of the present invention, the wavelength converting material and the specific nickel(II) dialkyldithiocarbamate deactivating singlet oxygen are contained in the same layer, whereby the deterioration of the wavelength converting material is suppressed to improve weather resistance.

### <Agricultural film>

The wavelength conversion film of the present invention absorbs light in a specific wavelength range of the sunlight, and emits light in different wavelength depending on types of plants, which is effective for plant growth. Thus, it is ideal for an agricultural film for greenhouse, etc. With respect to the wavelength conversion film of the present invention, in a case where the laminated film is used as an agricultural film, the ultraviolet blocking layer is provided on the sunlight incident side as compared with the wavelength converting layer.

As the agricultural film, the wavelength conversion film is preferred in that the intensity of the transmitted light (the light intensity after conversion) is higher than the intensity of incoming sunlight with at least a part of wavelength in a range of from 400 to 700nm, when the sunlight comes.

That is, in the range of the wavelength of the sunlight (300 nm to 2,500 nm), the wavelength of visible light, which is from 400 to 700 nm, is considered to be indispensable for growth of plants. The range of wavelength of light after wavelength conversion can be adjusted by appropriately selecting the wavelength converting material.

As the light influencing the growth of plants, the followings are reported:
red light (with a wavelength around 660 nm), which promotes germination or rooting;
far-red light (with a wavelength around 730 nm), which inhibits germination or rooting;
near-ultraviolet light (with a wavelength around 370 nm to 380 nm), which inhibits hypocotyl elongation;
blue light (with a wavelength around 440 nm to 480 nm), which brings phototropism;
far-red light (with a wavelength around 730 nm), which promotes petiole elongation;
light with a wavelength of 636 nm or around 650 nm, which promotes greening (chlorophyll biosynthesis promotion);
light with a wavelength of 430 nm or around 670 nm (maximum wavelength), which promotes growth (photosynthesis);
red and far-red light, which is influential over photoperiodism of short-day or long-day and promotes flowering;
ultraviolet light, which changes the color of a fruit or a flower by increasing a phenolic pigment or an anthocyanin pigment, and the like.

The intensity of light is represented by photosynthetically active radiation (PAR). That is, the relation between photosynthesis and energy from the sunlight should be discussed not in terms of intensity but in terms of PAR. PAR is the value of integral of spectral radiant energy (spectral irradiance) of each wavelength from 400 to 700 nm, which is the wavelength of visible light.

From the viewpoint of promotion of growth of plants, PAR of the transmitted light through the agricultural film is necessarily at least 10% of the PAR of the sunlight in each three range of from 400 to 500 nm, from 500 to 600 nm and from 600 to 700 nm.

The agricultural film of the present invention may be an agricultural film wherein a droplet flowing layer containing silica, alumina, etc. is formed on one side or on both sides thereof.

Depending on the reflective index of the thermoplastic resin, from 60 to 80% of the light emitted by the wavelength converting material may be reflected on the interface between the agricultural film and air, and diffuse in the film. In many cases, the absorption spectrum of the wavelength converting material overlaps with its emission spectrum, and thus a part of the light in the film will be absorbed again by the wavelength converting material. In order to avoid this energy loss, and to let the light emitted by the wavelength converting material be radiated from the film effectively, an ingenious application may be attempted. Such application may, for example, be:
(i) to make the agricultural film contain an inorganic powder such as silica or alumina; or
(ii) to form a regular concavo-convex pattern on the inner surface of the agricultural film, as described in JP-A-63-160520.

When the agricultural film as described above, which has the wavelength converting function, is used for a greenhouse, further improvements of yield and quality of crops, adjustment of picking season, reducing the period of cultivation, etc. are accomplished.

### <Cover film for photovoltaic generation>

The wavelength conversion film of the present invention is also suitable for a cover film of panal for photovoltaic generation because it absorbs light having a specific range of wavelength in the sunlight, and it emits light having a different range of wavelength which is effective for photovoltaic generation.

### EXAMPLES

Now, the present invention will be described in detail with reference to Examples. It should be understood, however, that the present invention is by no means limited to these Examples.

Examples 1 to 5 are Examples of the present invention, and Examples 6 to 11 are Comparative Examples.

### (Visible light transmittance)

The visible light transmittance of the wavelength conversion film was measured in accordance with JIS R3106 "Test method for transmittance, reflectance, emissivity, solar radiation heat acquiring efficiency of sheet glass" by using a spectrophotometer (UV-3100PC, manufactured by Shimadzu Corporation).

### (Accelerated weather resistant test)

With respect to the wavelength conversion film, a 10,000-hour weather resistant test was carried out by using a sunshine weather meter equipped with open-flame carbon-arc lamps in accordance with JIS K7350-4 (300 Sunshine weather meter, manufactured by Suga Test Instruments Co., Ltd.).

### (Spectral irradiance)

By using a visible-grating spectroradiometer (MS700, manufactured by Eko Instruments Co., Ltd.), (i) the spectral irradiance of the sunlight, (ii) the spectral irradiance of the sunlight which transmitted through the wavelength conversion film kept without accelerated weather resistant test, and (iii) the spectral irradiance of the sunlight which transmitted through the wavelength conversion film after accelerated weather resistant test, were measured at the same time. The spectral irradiance was measured at selected hours when the weather was stable on February 4, 2010.

### (Photosynthetically active radiation)

The photosynthetically active radiation (PAR) was calculated from the spectral irradiance of from 400 to 700 nm; and (I) the PAR of the sunlight, (II) the PAR of the sunlight which transmitted through the wavelength conversion film kept without accelerated weather resistant test, and (iii) the PAR of the sunlight which transmitted through the wavelength conversion film after accelerated weather resistant test, were obtained. The calculated PAR was divided into three parts of ranges of from 400 to 500 nm (blue), from 500 to 600 nm (green), and from 600 to 700 nm (red), and, in each range, the PAR ratio without accelerated weather resistant test: (the PAR of the sunlight which transmitted through the wavelength conversion film kept without accelerated weather resistant test)/(the PAR of the sunlight) and the PAR ratio after accelerated weather resistant test: (the PAR of the sunlight which transmitted through the wavelength conversion film after accelerated weather resistant test)/(the PAR of the sunlight) were obtained.

### EXAMPLE 1

Production of inorganic ultraviolet blocking material:
100 g of cerium oxide covered with silica (SC4060, manufactured by Nippon Denko) was dispersed in 300 g of an isopropanol solution wherein 5 mass% of phenyl methyl silicone oil was dissolved. Then, isopropanol was volatilized at 70°C, followed by drying at 170°C for an hour to obtain a powder wherein the surface of the silica was hydrophobized. The obtained powder was milled by an impact mill to obtain an inorganic ultraviolet blocking material.

Production of wavelength conversion film:
As a wavelength conversion material, 5 g of a perylene colorant (Lumogen F red 305, manufactured by BASF), 2.5 g of nickel(II) diethyldithiocarbamate (manufactured by Tokyo Chemical Industry Co., LTD) and 25 g of the inorganic ultraviolet blocking material were dispersed into 20 kg of ETFE (FLUON ETFE88AXB, manufactured by Asahi Glass Company, Limited) and pelletized at 300°C by a twin-screw extruder. The pellets were extrusion molded at 300°C by a T-die to obtain a wavelength converting layer film having a thickness of 100 µm. The visible light transmittance of the wavelength conversion layer film was measured. The results are shown in Table 1.

With respect to the wavelength conversion film, the accelerated weather resistant test was performed.
(i) the spectral irradiance of the sunlight, (ii) the spectral irradiance of the sunlight which transmitted through the wavelength conversion film kept without accelerated weather resistant test, and (iii) the spectral irradiance of the sunlight which transmitted through the wavelength conversion film after accelerated weather resistant test, were measured at the same time, and in the same manner as in the above method, the PAR ratio without accelerated weather resistant test and the PAR ratio after accelerated weather resistant test were obtained. The results are shown in Table 1.

Compared to the natural sunlight which did not transmit through the film, the PAR of the sunlight which transmitted through the wavelength conversion film is totally low, however, the PAR of a red light range of from 600 to 700 nm is higher than the natural sunlight. Additionally, the change in PAR after the accelerated weather resistant test was slight.

### EXAMPLE 2

A wavelength conversion film was obtained in the same manner as in Example 1 except that nickel(II) dibutyldithiocarbamate was used instead of nickel(II) diethyldithiocarbamate.

The wavelength conversion film was evaluated in the same manner as in Example 1. The results are shown in Table 1.

### EXAMPLE 3

A wavelength conversion film was obtained in the same manner as in Example 1 except that the amount of nickel(II) diethyldithiocarbamate was changed to 1.25 g.

The wavelength conversion film was evaluated in the same manner as in Example 1. The results are shown in Table 1.

### EXAMPLE 4

A wavelength conversion film was obtained in the same manner as in Example 1 except that the amount of nickel(II) diethyldithiocarbamate was changed to 1.0 g.

The wavelength conversion film was evaluated in the same manner as in Example 1. The results are shown in Table 1.

### EXAMPLE 5

A wavelength conversion film was obtained in the same manner as in Example 1 except that the amount of nickel(II) diethyldithiocarbamate was changed to 10.0 g.

The wavelength conversion film was evaluated in the same manner as in Example 1. The results are shown in Table 1.

### EXAMPLE 6

A wavelength conversion film was obtained in the same manner as in Example 1 except that the amount of nickel(II) diethyldithiocarbamate was changed to 0 g.

The wavelength conversion film was evaluated in the same manner as in Example 1. The results are shown in Table 1.

### EXAMPLE 7

A wavelength conversion film was obtained in the same manner as in Example 1 except that the amount of nickel(II) diethyldithiocarbamate was changed to 0.625 g.

The wavelength conversion film was evaluated in the same manner as in Example 1. The results are shown in Table 1.

### EXAMPLE 8

A wavelength conversion film was obtained in the same manner as in Example 1 except that the amount of nickel(II) diethyldithiocarbamate was changed to 15.0 g.

The wavelength conversion film was evaluated in the same manner as in Example 1. The results are shown in Table 1.

### EXAMPLE 9

A wavelength conversion film was obtained in the same manner as in Example 1 except that copper(II) diethyldithiocarbamate was used instead of nickel(II) diethyldithiocarbamate.

The wavelength conversion film was evaluated in the same manner as in Example 1. The results are shown in Table 1.

### EXAMPLE 10

A wavelength conversion film was obtained in the same manner as in Example 1 except that nickel(II) dihexyldithiocarbamate was used instead of nickel(II) diethyldithiocarbamate.

The wavelength conversion film was evaluated in the same manner as in Example 1. The results are shown in Table 1.

### EXAMPLE 11

A wavelength conversion film was obtained in the same manner as in Example 1 except that nickel(II) dibenzyldithiocarbamate was used instead of nickel(II) diethyldithiocarbamate.

The wavelength conversion film was evaluated in the same manner as in Example 1. The results are shown in Table 1.

**TABLE 1**

| Ex. | Singlet oxygen quencher | | Visible light transmittance (%) | PAR ratio (v.s. sunlight) | | | | | |
|---|---|---|---|---|---|---|---|---|---|
| | Type | Content per 100 parts by mass of the wavelength converting material (parts by mass) | | Without accelerated weather resistant test | | | After accelerated weather resistant test | | |
| | | | | 400-500 nm | 500-600 nm | 600-700 nm | 400-500 nm | 500-600 nm | 600-700 nm |
| 1 | Nickel(II) diethyldithiocarbamate | 50 | 76.6 | 0.80 | 0.75 | 1.05 | 0.82 | 0.77 | 1.05 |
| 2 | Nickel(II) dibutyldithiocarbamate | 50 | 77.3 | 0.82 | 0.76 | 1.05 | 0.86 | 0.79 | 1.04 |
| 3 | Nickel(II) diethyldithiocarbamate | 25 | 78.9 | 0.81 | 0.76 | 1.05 | 0.88 | 0.82 | 1.03 |
| 4 | Nickel(II) diethyldithiocarbamate | 20 | 78.9 | 0.81 | 0.76 | 1.06 | 0.89 | 0.84 | 1.03 |
| 5 | Nickel(II) diethyldithiocarbamate | 200 | 75.2 | 0.79 | 0.74 | 1.05 | 0.88 | 0.80 | 1.04 |
| 6 | No | - | 78.8 | 0.81 | 0.75 | 1.06 | 0.91 | 0.90 | 0.99 |
| 7 | Nickel(II) diethyldithiocarbamate | 12.5 | 78.9 | 0.81 | 0.75 | 1.06 | 0.90 | 0.89 | 0.99 |
| 8 | Nickel(II) diethyldithiocarbamate | 300 | 74.4 | 0.78 | 0.73 | 1.05 | 0.95 | 0.93 | 0.97 |
| 9 | Copper(II) diethyldithiocarbamate | 50 | 76.6 | 0.82 | 0.76 | 1.06 | 0.91 | 0.89 | 1.01 |
| 10 | Nickel(II) dihexyldithiocarbamate | 50 | 77.8 | 0.81 | 0.75 | 1.05 | 0.95 | 0.96 | 0.97 |
| 11 | Nickel(II) dibenzyldithiocarbamate | 50 | 76.5 | 0.80 | 0.75 | 1.05 | 0.96 | 0.97 | 0.97 |

### INDUSTRIAL APPLICABILITY

The wavelength conversion film of the present invention is useful for an agricultural film, a cover film for photovoltaic generation, etc.

The entire disclosure of Japanese Patent Application No. 2010-123176 filed on May 28, 2010 including specification, claims, drawings and summary is incorporated herein by reference in its entirety.

### REFERENCE OF SYMBOLS

1: Wavelength conversion film
2: Wavelength conversion film
10: Thermoplastic resin
12: Wavelength converting material
14: Specific nickel(II) dialkyldithiocarbamate
16: Inorganic ultraviolet blocking material
20: Wavelength converting layer
22: Ultraviolet blocking layer

## Claims

1. A wavelength conversion film comprising a single layered film consisting of a resin composition containing a thermoplastic resin, a wavelength converting material and a nickel(II) dialkyldithiocarbamate, or a laminated film having a wavelength converting layer consisting of the resin composition,
wherein the alkyl group of the nickel(II) dialkyldithiocarbamate is an ethyl group or a butyl group, and
the content of the nickel(II) dialkyldithiocarbamate is from 20 to 250 parts by mass per 100 parts by mass of the wavelength converting material.

2. The wavelength conversion film according to Claim 1, wherein the thermoplastic resin is a fluororesin.

3. The wavelength conversion film according to Claim 1 or 2, wherein the resin composition further contains an inorganic ultraviolet blocking material.

4. The wavelength conversion film according to Claim 1 or 2, wherein the laminated film further has an ultraviolet blocking layer containing an inorganic ultraviolet blocking material.

5. The wavelength conversion film according to any one of Claims 1 to 4, wherein the wavelength converting material is a perylene colorant.

6. The wavelength conversion film according to any one of Claim 1 to 5, wherein the resin composition consists of only the thermoplastic resin, the wavelength converting material and the nickel(II) dialkyldithiocarbamate.

7. The wavelength conversion film according to any one of Claim 1 to 5, wherein the resin composition consists of only the thermoplastic resin, the wavelength converting material, the nickel(II) dialkyldithiocarbamate and the inorganic ultraviolet blocking material.

8. The wavelength conversion film according to any one of Claim 1 to 7, wherein the content of the wavelength converting material is from 0.005 to 0.10 mass% per 100 mass% of the resin composition.

9. The wavelength conversion film according to any one of Claims 1 to 8, wherein the thermoplastic resin is an ethylene/tetrafluoroethylene copolymer or a vinylidene fluoride polymer.

10. An agricultural film using the wavelength conversion film according to any one of Claims 1 to 9.

11. A cover film for photovoltaic generation, using the wavelength conversion film according to any one of Claims 1 to 9.
